# EUROPÄISCHE PATENTSCHRIFT

(11) **EP 1 658 344 B1**
(45) Veröffentlichungstag und Bekanntmachung des Hinweises auf die Patenterteilung: **10.01.2007**
(21) Anmeldenummer: 04762615.5
(22) Anmeldetag: 06.08.2004
(51) Int. Cl.: C09J 5/06

(54) **MIKROSYSTEMBAUELEMENT UND VERFAHREN ZUM KLEBEN VON MIKROBAUTEILEN AUF EIN SUBSTRAT**
MICROSYSTEM COMPONENT AND METHOD FOR GLUING MICROCOMPONENTS TO A SUBSTRATE
COMPOSANT DE MICRO-SYSTEME ET PROCEDE DE COLLAGE DE MICROCOMPOSANTS SUR UN SUBSTRAT

(30) Priorität: 25.08.2003 DE 10338967
(43) Veröffentlichungstag der Anmeldung: 24.05.2006
(73) Patentinhaber: Technische Universität Braunschweig, 38106 Braunschweig (DE)
(72) Erfinder: BÖHM, Stefan, 52477 Alsdorf (DE); DILGER, Klaus, 38106 Braunschweig (DE); STAMMEN, Elisabeth, 52379 Langerwehe (DE); MUND, Frank, 40223 Düsseldorf (DE); POKAR, Gero, 38144 Braunschweig (DE); WREGE, Jan, 38302 Wolfenbüttel (DE)
(74) Vertreter: Gerstein, Hans Joachim
(86) Internationale Anmeldenummer: PCT/DE2004/001770
(87) Internationale Veröffentlichungsnummer: WO 2005/021669

(56) Entgegenhaltungen:
- WO-A-02/090454
- DE-A- 3 739 333
- DE-A- 19 819 054
- US-B1- 6 515 048

## Beschreibung

Die Erfindung betrifft ein Verfahren zum Kleben von Mikrobauteilen auf ein Substrat bei der Herstellung von Mikrosystembauelementen.

Die Erfindung betrifft weiterhin ein Mikrosystembauelement mit mindestens einem auf ein Substrat geklebtem Mikrobauteil.

In der Mikrosystemtechnik werden vielfach elektronische, elektromechanische oder rein mechanische Mikrobauteile auf ein Substrat geklebt. Die hierbei erforderliche Präzision, die geringen Klebflächen und die Notwendigkeit der Automatisierung des Fügevorgangs stellen hierbei ein besonderes Problem dar. Herkömmlicherweise erfolgt das Kleben von Mikrobauteilen mit viskosen Klebstoffen als Ein- oder Zwei-Komponentensysteme, die eine spezifische Topfzeit haben, innerhalb der die Klebeeigenschaften erhalten bleiben und der Klebvorgang durchgeführt werden kann. Viskose Klebstoffe haben zudem eine spezifische Aushärtezeit, die der Klebstoff benötigt, um eine stabile Klebverbindung zu gewährleisten.

In den Druckschriften US 6,126,765; US 2003/0029724 A1 und WO 98/45693 werden derartige Verfahren zum Verkleben von Mikrostrukturen mit viskosen Schmelzklebstoffen beschrieben.

Die Topfzeit sollte möglichst groß sein, um ein rationelles Fügen von Mikrobau-teilen durch großflächiges Auftragen des Klebstoffs auf das Substrat und an-schließendes Fügen einer Vielzahl von Mikrobauteilen auf das Substrat in einer für den Vorgang erforderlichen Zeit zu ermöglichen. Auf der anderen Seite sollte die Topfzeit und Aushärtezeit möglichst klein sein, damit die Klebverbindung nach dem Fügen sofort aushärtet und die Mikrobauteile sich nicht auf dem Substrat verschieben. Diese beiden konträren Randbedingungen sind kaum miteinander in Einklang zu bringen. Erschwerend hinzu kommt die in der Mikrosystemtechnik erforderliche geringe Schichtdicke des Klebstofffilms im µm-Bereich im Unterschied zur makroskopischen Klebung.

In der DE 198 50 041 A1 wird ein mikrotechnologisches Bondverfahren zur Herstellung einer Klebverbindung mit einem flüssigen oder pastösen Schmelzklebstoff beschrieben, der zumindest eine Viskosität derart aufweist, um als Kleberfaden mit einem definierten Querschnitt auf einem der Fügepartner plaziert zu werden. Die Klebewirkung entfaltet sich erst bei spezifischen äußeren Einwirkungen, beispielsweise Erwärmung des Klebstoffes, sodass der Kleberfaden aufgrund der noch nicht vorhandenen oder nur geringen Haftungstendenz verschoben werden kann. Dies kann aber dazu führen, dass die gewünschte Klebefläche nur noch teilweise mit der erforderlichen Klebstoffmenge benetzt ist, was zu deutlicher Verringerung der Fügequalität führt.

In der DE 37 39 333 A1 wird ein Verfahren zur Herstellung von Schmelzklebeverbindungen beschrieben, in der ein Laser als Wärmequelle verwendet wird. Das Verfahren sieht vor, dass die zu verklebenden Wafer rückseitig in einer Lackschleuderanlage mit einer Schmelzkleberlösung bzw. mit einem Klebelack beschichtet oder mit einer Folienbügelanlage mittels einer Klebefolie kaschiert werden. Anschließend werden die Wafer wie üblich zersägt und die vereinzelten Chips getrocknet. Die Chips werden nun im Takt gleichzeitig vom Wafer abgehoben und paarig mit dem Laser fixiert. Die Energie des Laserstrahls dient hier zum Aufschmelzen des Klebstoffes, um die Fügung der Partner herzustellen.

Aufgabe der Erfindung ist es daher, ein verbessertes Verfahren zum Kleben von Mikrobauteilen auf ein Substrat zur Herstellung von Mirkosystembauelementen zu schaffen, das ein rationelles Fügen einer Vielzahl von Mikrobauteilen einzeln nacheinander oder vorzugsweise in einem Schritt ermöglicht und ein Verschieben der Mikrobauteile unter Berücksichtigung der hohen Genauigkeitsanforderungen in der Mikrosystemtechnik nach dem Aufbringen der Mikrobauteile auf das Substrat verhindert.

Diese Aufgabe wird mit dem gattungsgemäßen Verfahren erfindungsgemäß dadurch gelöst, dass pulverförmiger Schmelzklebstoff flächig auf die Oberfläche des Substrats oder Mikrobauteils aufgetragen, ausgewählte Klebestellen durch lokale Erwärmung mittels Bestrahlung der ausgewählten Klebestellen durch eine fokussierbare Wärmequelle angeschmolzen und die nicht angeschmolzene Pulverschicht entfernt wird. Anschließend erfolgt dann das Aufkleben des mindestens einen Mikrobauteils auf das Substrat durch Aufbringen der Mikrobauteile auf das Substrat und nochmalige Erwärmung des Verbundes.

Reaktive oder nicht reaktive Schmelzklebstoffe sind grundsätzlich aus der Makrotechnik bekannt. Im Unterschied zu den viskosen Klebstoffen erfolgt die Klebung beim Abkühlen sofort ohne Aushärtezeit, nachdem der Schmelzklebstoff über die Schmelztemperatur erwärmt wurde. In Abhängigkeit vom Schmelzklebstoff ist die Klebverbindung reversibel oder irreversibel. Bei reaktiven bzw. nahvernetzenden Schmelzklebstoffen ist die Klebverbindung nicht reversibel, sobald die Reaktion bzw. Nahvernetzung gestartet wurde. Bei einer reversiblen Klebverbindung kann das Mikrobauteil nach Erwärmen über eine spezifische Temperatur wieder abgelöst werden.

Allerdings ist sowohl bei der reversiblen, als auch bei der irreversiblen Klebverbindung ein Anhaften des Mikrobauteils an dem Substrat gewährleistet, bei dem das Mikrobauteil sich nicht mehr verschiebt, auch nicht um geringste Entfernungen im µm-Bereich.

Schmelzklebstoffe sind Klebstoffe, die durch Wärmeeinwirkung aufschmelzen und bei Erstarren die Klebverbindung bilden. Übliche Schmelzklebstoffe sind beispielsweise Mischungen von Ethylen-Vinylacetat-Copolymeren, Polyamiden oder gesättigten Polyestern mit Zusätzen wie Harzen, Weichmachern, Stabilisatoren oder Füllstoffen.

Im Unterschied hierzu sind Reaktionsklebstoffe zu sehen, die durch chemische Reaktion abbinden. Dabei stellt sich jedoch das oben genannte Problem der Topf- und Abbindezeit. Weiterhin sind anlösende Klebstoffe bekannt, die die zu verklebenden Oberflächen anlösen, so dass nach Diffusion der Makromoleküle und Verdunstung des Lösemittels die Klebung eintritt. Auch hier ist die Reaktionszeit zu lang. Alles-Kleber binden ebenfalls durch Verdunsten von Lösungsmittel ab.

Die reaktiven oder nicht reaktiven Schmelzklebstoffe sind auch im Unterschied zu herkömmlichen Haftklebstoffen zu sehen, die als dauerklebrige Klebstoffe zumeist auf Kautschukbasis bei geringem Druck haften, bei dauernder Last jedoch zum Kriechen neigen. Ungeeignet sind auch Kontaktklebstoffe, die auf beide zu verklebenden Oberflächen aufgetragen werden müssen, wobei nach einer Vortrocknung die Klebung durch kurzzeitiges, starkes Zusammendrücken erfolgt.

Reaktive oder nicht reaktive Schmelzklebstoffe zeichnen sich als physikalisch abbindende Klebstoffe dadurch aus, dass ein einseitiges Auftragen und Anliegen der Klebflächen zur Herstellung einer Klebverbindung ausreicht, wobei ein Wärmeeintrag vor oder nach dem Auftragen erfolgt. Die Aushärtung erfolgt durch Abkühlung, so dass die Aushärtezeit beliebig klein eingestellt werden kann und so ein Verschieben der Mikrobauteile auf dem Substrat während der Klebung verhindert wird.

Schmelzklebstoffe haben zudem den Vorteil, dass die Klebverbindung reversibel ist, durch ein Nachhärteprozess jedoch auch irreversibel gemacht werden kann.

Die Schmelzklebstoffe werden vorzugsweise als Granulat mit beliebiger Form, vorzugsweise kugelförmig, aufgetragen.

Das Anschmelzen der ausgewählten Klebestellen kann lokal, beispielsweise mittels fokussierender Wärmequelle einer Laserbestrahlung der ausgewählten Klebstellen oder global durch Erwärmen des gesamten Substrates oder Mikrobauteils beispielsweise mittels Heizplatte oder Infrarotstrahlung erfolgen.

Das Auftragen des Schmelzklebstoffs kann auch durch Eintauchen einer ggf. erwärmten strukturierten Oberfläche des Substrates oder Mikrobauteils in pulverförmigen Schmelzklebstoff durchgeführt werden.

Das Auftragen des pulverförmigen Schmelzklebstoffs kann auch mit Hilfe eines konturierten Siebs oder einer Maske erfolgen.

Es ist aber auch denkbar, die ausgewählten Klebstellen elektrostatisch aufzuladen und den pulverförmigen Schmelzklebstoff auf die teilweise elektrostatisch geladene Oberfläche des Substrats oder Mikrobauteils flächig aufzutragen.

Ebenfalls möglich ist das elektrostatische Aufladen einer Walze, von der dann pulverförmige Schmelzklebstoffe auf das Substrat oder Mikrobauteil übertragen werden.

Durch kurzzeitiges Erwärmen der Oberfläche erfolgt dann ein Anschmelzen des Klebstoffs an den elektrostatisch geladenen Klebstellen. Anschließend können die Mikrobauteile einzeln oder gleichzeitig auf das Substrat aufgelegt und durch Erwärmen des Verbundes angeklebt werden.

Der Schmelzklebstoff kann auch durch Auflegen einer Transferfolie mit daran anhaftendem granulatförmigen oder pulverförmigem Klebstoff oder eine Folie aus dem Schmelzklebstoff selbst auf die zu klebende Oberfläche des Mikrobauteils oder Substrats aufgebracht werden. Die Folie wird zur Auswahl von Klebstellen vorzugsweise konturiert. Es kann aber auch ein mechanisches Stempeln der Folie auf das Substrat oder Mikrobauteil oder eine lokale Erwärmung der Folie an ausgewählten Klebstellen erfolgen, um den auf der Folie haftenden Klebstoff auf die ausgewählten Klebstellen zu transferieren.

Nach dem Aufkleben des mindestens einen Mikrobauteils auf das Substrat wird vorzugsweise eine Nacherwärmung des Systembauelementes durchgeführt, um eine Verklebung zu erreichen. Die Nacherwärmung kann hierbei selektiv beispielsweise mittels Laser oder global erfolgen.

Die Granulate der Klebstoffe sollten einen Durchmesser von weniger als 150 µm haben und vorzugsweise im Bereich von 0,5 bis 150 µm liegen.

Die Granulate können hierbei eine beliebige Form, beispielsweise eine Kugelform, haben.

Die Aufgabe wird weiterhin durch das Mikrosystembauelement gelöst, bei dem die Klebverbindung zwischen Substrat und Mikrobauteilen mit Schmelzklebstoff ausgeführt ist. Dabei sind die Mikrobauteile vorzugsweise kleiner als 1000 µm.

Die Erfindung wird nachfolgend anhand der beigefügten Zeichnungen näher erläutert. Es zeigen:
- Figur 1 -: Skizze des Verfahrens zum Kleben von Mikrobauteilen mittels Auftragens eines kugelförmigen Schmelzklebstoffs auf eine glatte oder strukturierte Oberfläche;
- Figur 2 -: Skizze des Verfahrens zum elektrostatischen Aufladen einer definierten Klebfläche;
- Figur 3 -: Skizze des Verfahrens zum Auftragen eines pulverförmigen Schmelzklebstoff großflächig auf die Substratoberfläche;
- Figur 4 -: Skizze eines Verfahrens zum Kleben von Mikrobauteilen mit großflächigem Auftragen von Klebstoff und Anschmelzen oder Ansintern ausgewählter Klebflächen mit Hilfe einer fokussierten Wärmequelle;
- Figur 5 -: Skizze der Oberfläche aus Figur 3 und Figur 4 mit nur an den Klebestellen durch elektrostatische Aufladung, Anschmelzung oder Ansinterung verbleibendem Klebstoff;
- Figur 6 -: Skizze eines Verfahrens zum Auftragen von elektrostatisch aufgeladenen pulverförmigen Klebstoff oder dispergierten Schmelzklebstoffs mit Hilfe einer Walze;
- Figur 7 -: Skizze eines Verfahrens zum Auftragen von Klebstoff auf ausgewählte Klebstellen durch Eintauchen einer erhabenen Struktur in pulverförmigen Klebstoff oder eine Dispersion;
- Figur 8 -: Skizze eines Verfahrens zum Auftragen von Klebstoff mittels Siebdruck;
- Figur 9 -: Skizze eines Verfahrens zum Auftragen eines Klebstoffs mit Hilfe eines Transferbandes oder einer aus Schmelzklebstoff hergestellten Folie;
- Figur 10 -: Skizze eines Verfahrens zum Auftragen von Klebstoff mit einem Transferband für konturierte Schmelzklebstoffe;
- Figur 11 -: Skizze des Verfahrens zum Auftragen von Klebstoff auf eine Transferfolie oder einem Substrat, wobei konturierte Klebststoffabschnitte auf die Transferfolie oder dem Substrat abgelegt werden;
- Figur 12 -: Skizze des Verfahrens zum Auftragen eines Klebstoffs durch Eintauchen eines Mikrobauteils in pulverförmigen Schmelzklebstoff oder eine Dispersion.

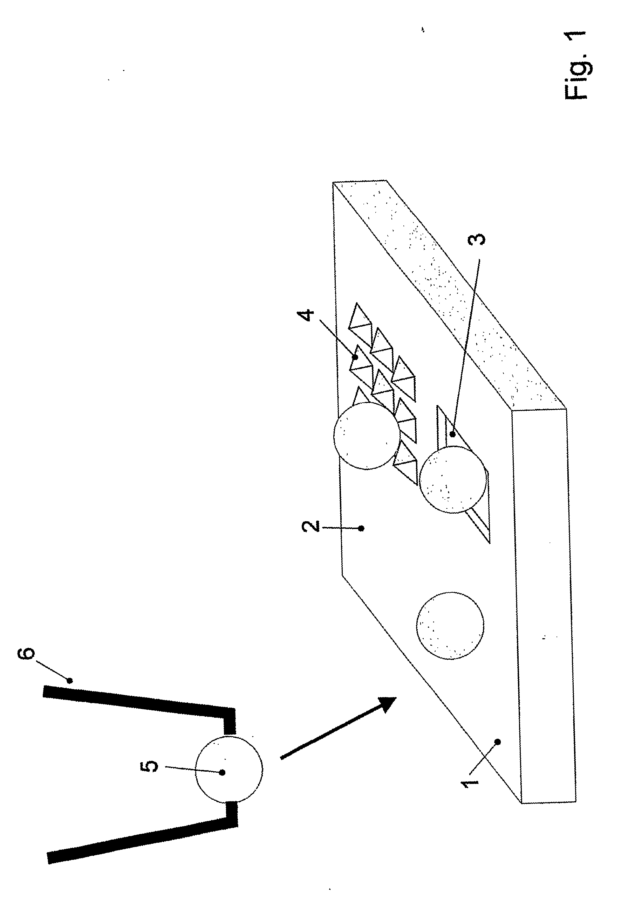

Die Figur 1 lässt eine Ausführungsform des Verfahrens zum Kleben von Mikrobauteilen auf ein Substrat 1 erkennen. Das Substrat 1 hat entweder eine glatte Oberfläche 2 oder eine strukturierte Oberfläche mit Vertiefungen 3 oder Erhebungen 4. Der Klebstoff 5 wird in Form eines granulatförmigen reaktiven oder nicht reaktiven Schmelzklebstoffs mit Hilfe eines Greifers 6 einzeln auf die Klebeflächen genau abgelegt. Vor allem durch die strukturierte und/oder erwärmte Oberfläche verharrt der granulatförmige Klebstoff 5 in seiner Position. Die Form der Granulate kann beliebig sein, beispielsweise quaderförmig, prismenförmig, wie dargestellt kugelförmig, oder regellos.

Nachdem der Klebstoff 5 derart aufgetragen wurde, wird dieser erwärmt und mindestens ein Mikrobauteil auf die mit Klebstoff 5 versehenen Klebflächen des Substrates 1 aufgelegt. Das Erwärmen kann auch bereits während des Auftragens mit einem vorgewärmten Greifer 6 erfolgen. Als Greifer 6 kann auch eine Nadel zum Aufnehmen und Platzieren der Klebstoffgranulate eingesetzt werden. Beim Abkühlen wird sofort eine nicht verschiebliche Klebverbindung zwischen Mikrobauteil und Substrat 1 hergestellt.

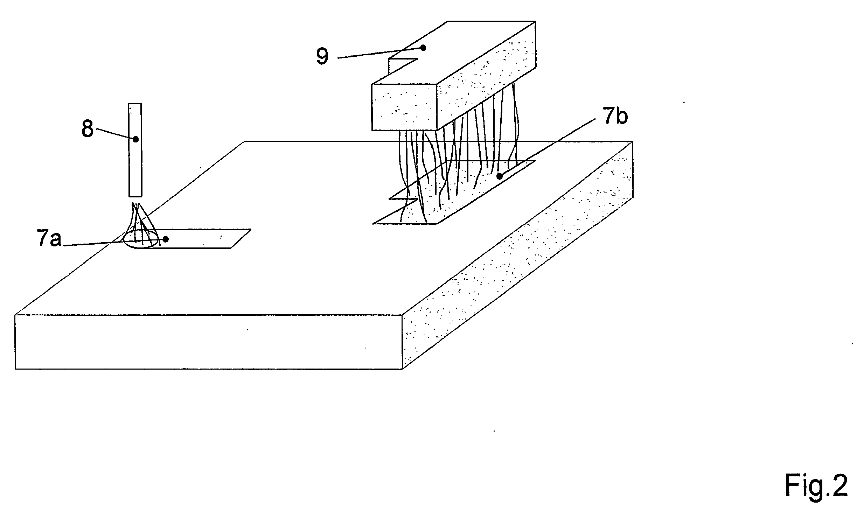

Die Figur 2 lässt eine andere Ausführungsform des Verfahrens zum Auftragen eines Klebstoffs 5 zum Herstellen von Mikrosystembauelementen erkennen. Hierbei werden ausgewählte Klebflächen 7a mit Hilfe einer Elektrode 8 elektrostatisch aufgeladen. Die Elektrode 8 wird hierbei über die zu klebenden Flächen 7a verfahren, so dass diese in beliebiger Form leicht konturiert werden können.

In einer anderen Ausführungsform erfolgt das elektrostatische Aufladen der Klebfläche 7b mit einer geometrisch an die Form der Klebfläche 7b angepassten Elektrode 9 oder Maske.

Anschließend kann der Klebstoff 5 mit einem Greifer 6 einzeln aufgelegt oder in Pulverform aufgestreut werden. Die elektrostatische vorgeladene Oberfläche des Substrates 1 kann auch in pulverförmigen Klebstoff 5 eingetaucht werden.

Wie oben bereits beschrieben, erfolgt dann ein Erwärmen des derart lokal aufgetragenen Klebstoffs und Aufbringen des mindestens einen Mikroteils auf das Substrat 1.

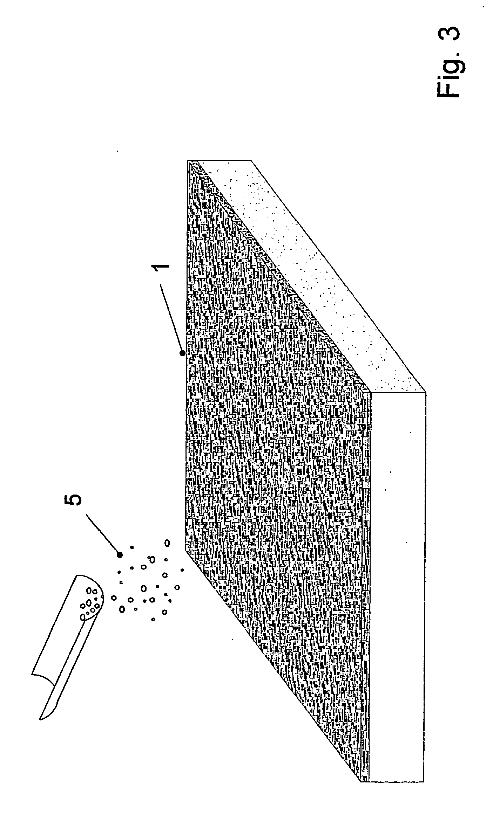

Die Figur 3 lässt ein Verfahren zum Auftragen eines pulverförmigen Klebstoffs 5 großflächig auf die Oberfläche eines Substrates 1 erkennen.

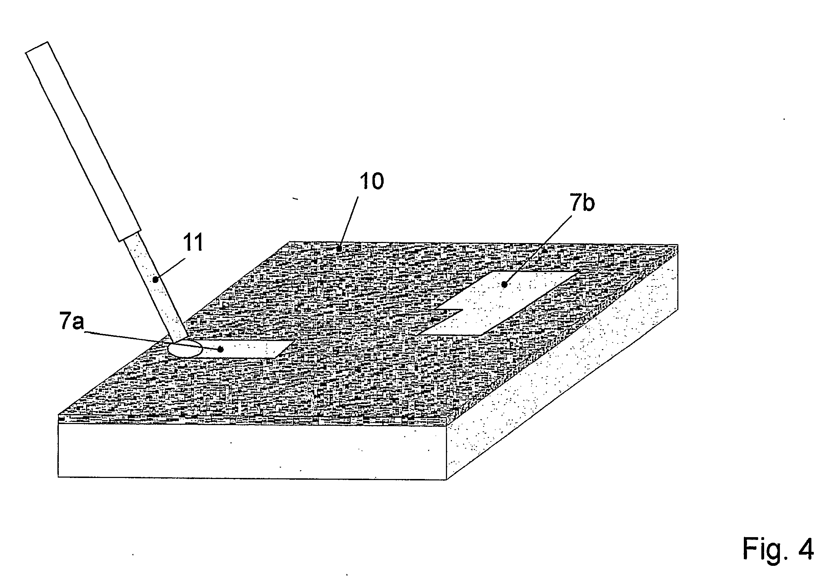

In einem folgenden Schritt, der in der Figur 4 skizziert ist, wird der pulverförmige Klebstoff 5 an den ausgewählten Klebeflächen 7 durch lokale Erwärmung mit einer fokussierbaren Wärmequelle, wie beispielsweise einem Laserstrahl, einem Infrarot-Lichtstrahl, einem UV-Lichtstrahl etc. angeschmolzen oder angesintert. Alternativ können die Klebflächen auch wie in der Figur 2 gezeigt vorher elektrostatisch aufgeladen werden. Der pulverförmige Klebstoff 5 wird dann von den nicht zu verklebenden Flächen 10 des Substrates 1 entfernt.

Das Anschmelzen oder Ansintern ausgewählter Klebeflächen 7 des wie in der Figur 3 skizziert großflächig mit pulverförmigen Klebstoff 5 beschichteten Substrates 1 kann auch durch Abdecken der nicht zu verklebenden Flächen 10 mit einer reflektierenden Maske und großflächigem Bestrahlen der Oberfläche des Substrates 1 mit einer Wärmequelle erfolgen.

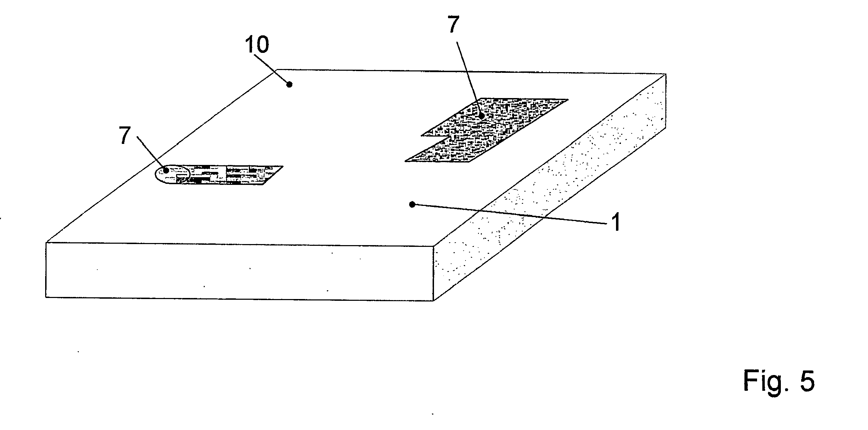

Wie in der Figur 5 gezeigt ist, bleibt durch das Anschmelzen oder Ansintern der Klebstoff 5 an den ausgewählten Klebstellen 7 haften und kann von den nicht zu verklebenden Flächen 10 leicht entfernt werden.

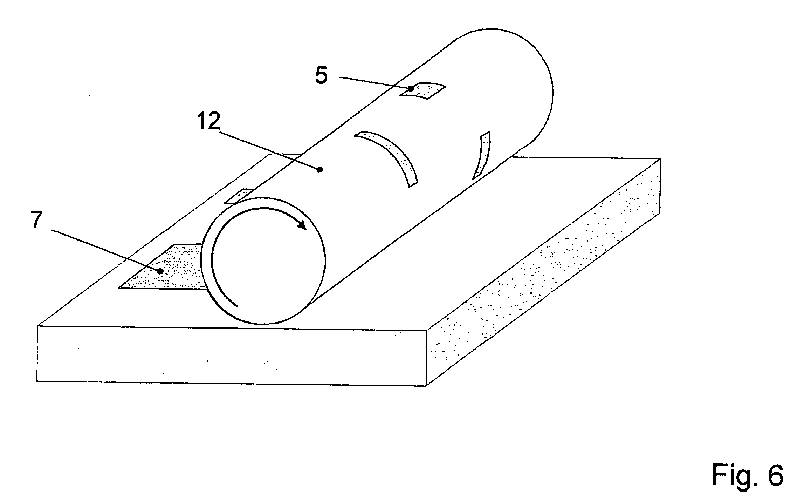

Die Figur 6 lässt eine andere Ausführungsform des Verfahrens zum Auftragen eines Klebstoffs 5 in Form eines elektrostatisch aufgeladenen pulverförmigen Schmelzklebstoffs oder einer Dispersion eines Schmelzklebstoffs erkennen. Der Klebstoff 5 wird dabei auf eine elektrostatisch geladene oder konturierte Walze 12 aufgebracht, die relativ zu der Oberfläche des Substrates 1 bewegt wird. Hierdurch wird der gezielt lokal auf der Oberfläche der Walze 12 haftende Klebstoff 5 auf die ausgewählten Klebflächen 7 transferiert.

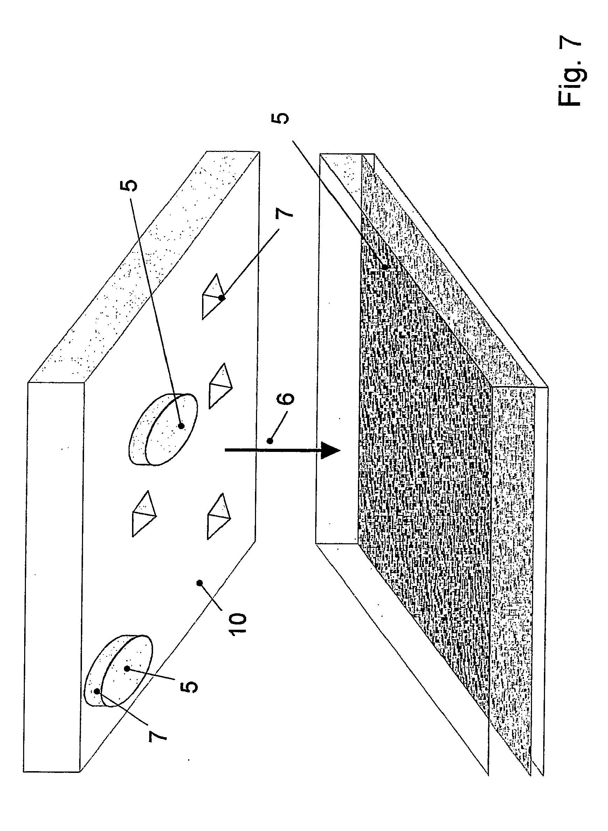

Die Figur 7 lässt eine andere Ausführungsform des Verfahrens zum Auftragen eines Klebstoffs 5 auf ausgewählte Klebstellen eines Substrates 1 oder Mikrobauteils erkennen. Das Substrat 1 oder Mikrobauteil hat an den ausgewählten Klebeflächen 7 eine erhabene Struktur, die in pulverförmigen Klebstoff oder eine Dispersion eines Schmelzklebstoffs eingetaucht wird. Die erhabenen Klebflächen 7 werden auf dieser Weise mit Klebstoff 5 benetzt und die nicht zu klebenden Flächen 10 des Substrates 1 bleiben unbeschichtet.

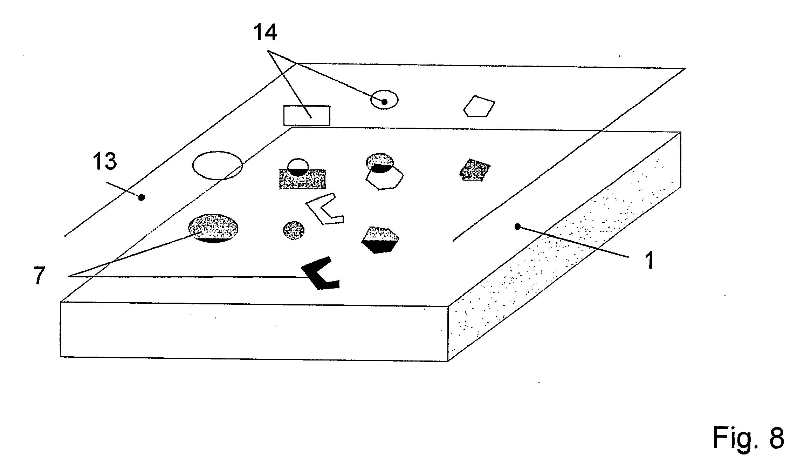

Die Figur 8 lässt eine andere Ausführungsform zum Auftragen von Klebstoff 5 in Form eines pulverförmigen Schmelzklebstoffs oder einer Dispersion eines solchen Klebstoffs 5 erkennen. Der Klebstoff 5 wird hierbei durch ein konturiertes Sieb gestreut oder mit Hilfe eines Siebdruckverfahren als Dispersion mit Hilfe eines Siebes 13, das den ausgewählten Klebeflächen 7 entsprechende Sieböffnungen 14 hat, aufgetragen.

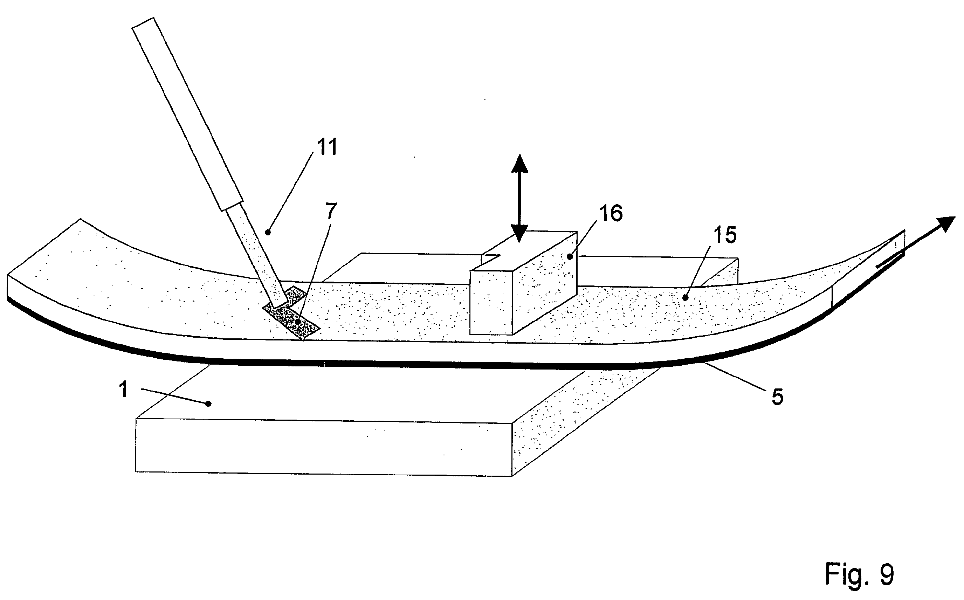

Die Figuren 9 bis 11 lassen eine andere Methode zum Auftragen von Klebstoff 5 auf ein Substrat 1 oder Mikrobauteil mit Hilfe einer Transferfolie 15 erkennen. Die Transferfolie 15 kann ähnlich wie ein Schreibmaschinenband über die Oberfläche des Substrates 1 bewegt werden. Die Transferfolie 15 trägt auf der Oberfläche, die dem Substrat 1 zugewandt ist, den Schmelzklebstoff 5 als relativ dünne Schicht. Mit Hilfe einer fokussierten Wärmequelle 11, beispielsweise eines Lasers, wird die Folie an ausgewählten Stellen, die den Klebflächen 7 entsprechen, erwärmt und auf diese Weise der Klebstoff 5 auf die Oberfläche des Substrates 1 an den ausgewählten Klebstellen 7 angeheftet. Alternativ kann mit Hilfe eines konturierten Stempels 16 der Klebstoff 5 an den ausgewählten Klebstellen 5 mechanisch auf die Oberfläche des Substrates 1 aufgedrückt werden. Die transferbandartige Folie 15 wird, wie durch den Pfeil skizziert, kontinuierlich oder diskontinuierlich relativ zur Oberfläche des Substrates 1 bewegt, so dass immer vollständige Klebstoffflächen zum Auftragen auf das Substrat 1 verfügbar sind.

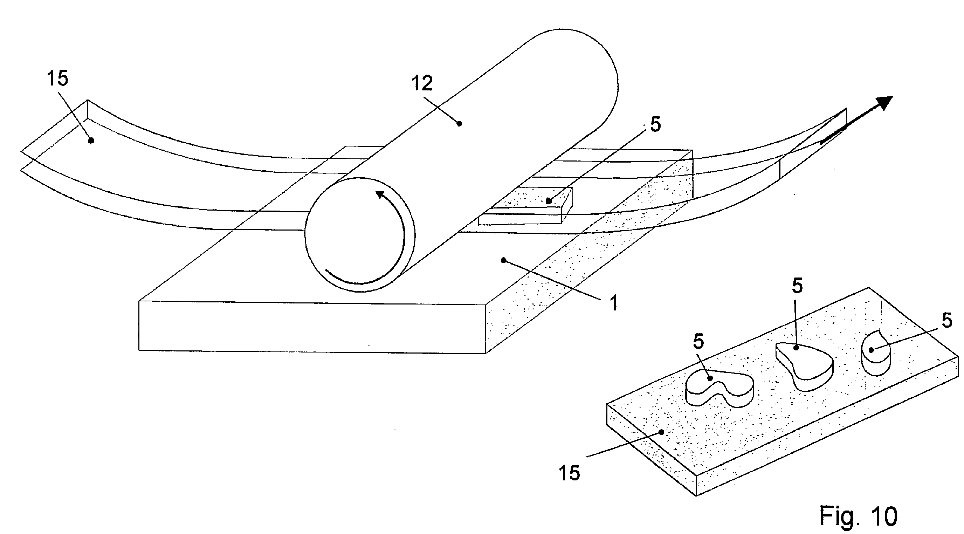

Die Figur 10 lässt eine anderen Ausführungsform des Aufbringens von Klebstoff 5 mit Hilfe einer Transferfolie 15 auf ein Substrat 1 und ein Mikrobauteil erkennen. Der Klebstoff 5 ist hierbei bereits in den Klebflächen 7 in entsprechender konturierter Form auf die Transferfolie 15 aufgetragen. Das Konturieren kann durch Ausschneiden beispielsweise mittels Laser oder Fräser erfolgen. Die Transferfolie 15 mit dem konturierten Klebstoff 5 wird dann auf die Oberfläche des Substrates 1 gelegt und mit einer Walze 12 angedrückt, so dass der Klebstoff 5 auf der Oberfläche des Substrates 1 haften bleibt.

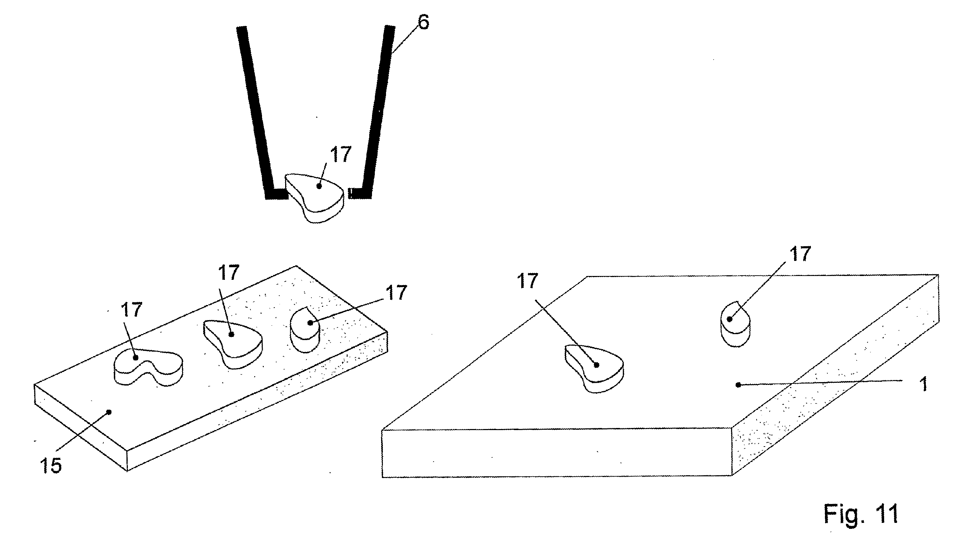

Die Figur 11 lässt eine andere Ausführungsform erkennen, bei der eine konturierte Klebstofffolie 17 mit einem Greifer 6 aufgegriffen und auf eine Transferfolie 15 gezielt abgelegt wird. Die Transferfolie 15 kann dann wie in der Figur 10 gezeigt auf das Substrat 1 aufgebracht werden. Die konturierte Klebstofffolie 17 kann aber auch, wie in der Figur 11 skizziert, unmittelbar auf das Substrat 1 an den ausgewählten Klebflächen 7 abgelegt werden.

Der Greifer 6 kann ein Sauggreifer, ein elektrostatisch geladener Greifer oder ein mechanischer Greifer, eine Nadel etc. sein.

Der Klebstoff 5 kann nicht nur auf die Oberfläche des Substrates 1, wie skizziert, sondern in entsprechender Weise auf die Mikrobauteile oder sowohl auf das Substrat 1 und die Mikrobauteile aufgetragen werden.

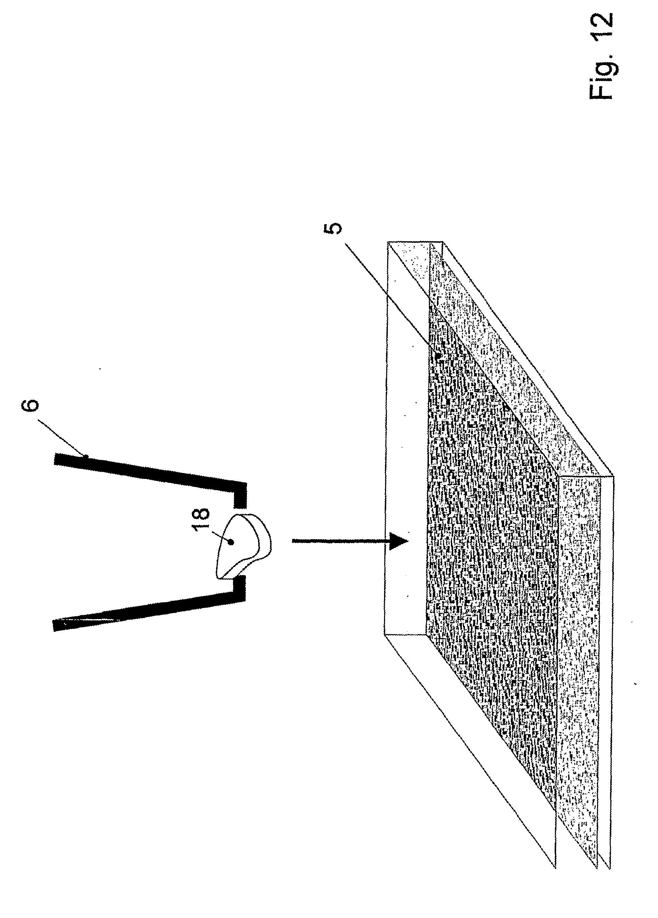

Hierbei kann, wie in der Figur 12 skizziert, das Mikrobauteil 18 mit einem Greifer 6 ergriffen und in ein Gefäß mit einer Dispersion eines Schmelzklebstoffs oder eines pulverförmigen Schmelzklebstoffs eingetaucht werden. Vorteilhaft ist es, wenn dabei das Mikrobauteil 18 erwärmt ist.

## Patentansprüche

1. Verfahren zum Kleben von Mikrobauteilen (18) auf ein Substrat (1) bei der Herstellung von Mikrosystembauelementen, mit folgenden Schritten:
- Auftragen eines reaktiven oder nicht reaktiven Schmelzklebstoffs (5) auf das Mikrobauteil (18) und/oder das Substrat (1);
- Erwärmen des Schmelzklebstoffs (5), und
- Aufbringen des mindestens einen Mikrobauteils (18) auf das Substrat (1), wobei der Schmelzklebstoff (5) auf den Kontaktflächen zwischen Mikrobauteil (18) und Substrat (1) ist, **gekennzeichnet durch**
- flächiges Auftragen von pulverförmigem Schmelzklebstoff (5) auf die Oberfläche des Substrates (1) oder Mikrobauteils (18),
- Anschmelzen ausgewählter Klebestellen (7) **durch** lokale Erwärmung mittels Bestrahlung der ausgewählten Klebestellen durch eine fokussierbare Wärmequelle (11) der Pulverschicht;
- Entfernen der nicht angeschmolzenen Pulverschicht; und
- Aufkleben des mindestens einen Mikrobauteils (18) auf das Substrat (1).

2. Verfahren nach Anspruch 1, **dadurch gekennzeichnet, dass** das Erwärmen selektiv mit einer fokussierenden Wärmequelle (11), insbesondere mittels Laser erfolgt.

3. Verfahren nach Anspruch 1 oder 2, **dadurch gekennzeichnet, dass** der Schmelzklebstoff (5) als Granulat aufgetragen wird.

4. Verfahren nach einem der vorhergehenden Ansprüche, **dadurch gekennzeichnet, dass** das Anschmelzen mit einem Laser erfolgt.

5. Ein Verfahren nach einem der vorhergehenden Ansprüche, **gekennzeichnet durch** Eintauchen eines erwärmten Substrates (1) oder Mikrobauteils (18) in pulverförmigen Schmelzklebstoff zum Auftragen des Klebstoffs (5) an den eingetauchten Flächen.

6. Verfahren nach einem der vorhergehenden Ansprüche, **gekennzeichnet durch** Aufbringen von pulverförmigen Schmelzklebstoff **durch** ein konturiertes Sieb (13) auf das Substrat (1) oder Mikrobauteil (18).

7. Verfahren nach einem der vorhergehenden Ansprüche, **gekennzeichnet durch** elektrostatisches Aufladen einer Oberfläche und/oder eines pulverförmigen Schmelzklebstoffs (5) zur Unterstützung des flächigen oder strukturierten Klebstoffauftrages.

8. Verfahren nach einem der vorhergehenden Ansprüche, **gekennzeichnet durch** Eintauchen einer erwärmten strukturierten Oberfläche des Substrates (1) oder Mikrobauteils (18) in pulverförmigen Schmelzklebstoff zum Auftragen des Klebstoffs (5) an den erhabenen Stellen der strukturierten Oberfläche.

9. Verfahren nach einem der vorhergehenden Ansprüche, **gekennzeichnet durch** elektrostatisches Aufladen einer Walze (12), flächiges Auftragen des pulverförmigen Schmelzklebstoffs auf die teilweise elektrostatisch geladene Oberfläche der Walze (12) und Übertragen der ausgewählten Klebestellen (7) von der Walze (12) auf das Substrat (1) oder Mikrobauteil (18), und kurzzeitiges Erwärmen der Oberfläche zum Anschmelzen des Klebstoffs (5).

10. Verfahren nach einem der vorhergehenden Ansprüche, **gekennzeichnet durch** elektrostatisches Aufladen der ausgewählten Klebestellen, flächiges Auftragen des pulverförmigen Schmelzklebstoffs auf die teilweise elektrostatisch geladene Oberfläche des Substrates (1) oder Mikrobauteils (18), und kurzzeitiges Erwärmen der Oberfläche zum Anschmelzen des Klebstoffs (5) an den elektrostatisch geladenen Klebestellen (7).

11. Verfahren nach Anspruch 1, **gekennzeichnet durch** Auflegen einer Transferfolie (15) mit daran anhaftendem granulatförmigen oder pulverförmigem Klebstoff (5) oder einer aus Schmelzklebstoff hergestellten Schicht auf die zu klebende Oberfläche des Mikrobauteils (18) oder Substrates (1).

12. Verfahren nach Anspruch 11, **gekennzeichnet durch** Konturieren der Transferfolie (15) zur Auswahl von Klebestellen (7).

13. Verfahren nach Anspruch 11, **gekennzeichnet durch** Auftragen des Klebstoffs (5) an ausgewählten Klebestellen (7), wenn die Transferfolie (15) auf der Oberfläche mindestens eines Mikrobauteils (18) oder Substrates (1) aufliegt, **durch** mechanisches Stempeln der Transferfolie (15) auf das Substrat (1) oder Mikrobauteil (18) oder lokale Erwärmung der Transferfolie (15).

14. Verfahren nach einem der vorhergehenden Ansprüche, **gekennzeichnet durch** Vorwärmen mindestens der Oberflächen, auf die Klebstoff (5) aufgetragen wird.

15. Verfahren nach einem der vorhergehenden Ansprüche, **gekennzeichnet durch** Nacherwärmung des Mikrosystembauelementes nach dem Aufkleben des mindestens einen Mikrobauteils (18) auf das Substrat (1).

16. Verfahren nach Anspruch 14, **dadurch gekennzeichnet, dass** die Nacherwärmung selektiv mittels fokussierender Wärmequelle (11) oder global erfolgt.

17. Verfahren nach einem der vorhergehenden Ansprüche, **dadurch gekennzeichnet, dass** die Granulate der Klebstoffe (5) einen Durchmesser von weniger als 150 µm haben.

18. Verfahren nach Anspruch 17, **dadurch gekennzeichnet, dass** der Durchmesser der Granulate im Bereich von 0,5 bis 150 µm liegt.

19. Mikrosystembauelement mit mindestens einem auf ein Substrat (1) geklebtes Mikrobauteil (18), **dadurch gekennzeichnet, dass** die Klebeverbindung nach dem Verfahren nach einem der Ansprüche 1 bis 18 ausgeführt ist.

20. Mikrosystembauelement nach Anspruch 19, **dadurch gekennzeichnet, dass** die Mikrobauteile (18) kleiner als 1.000 µm sind.

## Claims

1. A method for gluing microcomponents (18) to a substrate (1) in the production of microsystem components, comprising the following steps:
- applying a reactive or nonreactive hotmelt adhesive (5) to the microcomponent (18) and/or the substrate (1) ;
- heating the hotmelt adhesive (5), and
- applying the at least one microcomponent (18) to the substrate (1), the hotmelt adhesive (5) being on the contact areas between microcomponent (18) and substrate (1), **characterized by**
- areal application of pulverulent hotmelt adhesive (5) to the surface of the substrate (1) or microcomponent (18),
- incipient melting of selected bondsites (7) by local heating by means of irradiation of the selected bondsites through a focusable heat source (11) of the powder layer;
- removal of the powder layer not incipiently melted; and
- adhesion of the at least one microcomponent (18) to the substrate (1).

2. The method of claim 1, **characterized in that** the heating takes place selectively with a focusing heat source (11), in particular by means of laser.

3. The method of claim 1 or 2, **characterized in that** the hotmelt adhesive (5) is applied as granules.

4. The method of one of the preceding claims, **characterized in that** the incipient melting takes place with a laser.

5. A method of one of the preceding claims, **characterized by** immersing a heated substrate (1) or microcomponent (18) in pulverulent hotmelt adhesive to apply the adhesive (5) at the immersed areas.

6. The method of one of the preceding claims, **characterized by** application of pulverulent hotmelt adhesive through a contoured screen (13) to the substrate (1) or microcomponent (18).

7. The method of one of the preceding claims, **characterized by** electrostatic charging of a surface and/or a pulverulent hotmelt adhesive (5) to support the areal or patterned application of adhesive.

8. The method of one of the preceding claims, **characterized by** immersion of a heated patterned surface of the substrate (1) or microcomponent (18) in pulverulent hotmelt adhesive to apply the adhesive (5) at the raised sites on the patterned surface.

9. The method of one of the preceding claims, **characterized by** electrostatic charging of a roll (12), areal application of the pulverulent hotmelt adhesive to the partly electrostatically charged surface of the roll (12) and transfer of the selected bondsites (7) from the roll (12) to the substrate (1) or microcomponent (18), and brief heating of the surface to incipiently melt the adhesive (5).

10. The method of one of the preceding claims, **characterized by** electrostatic charging of the selected bondsites, areal application of the pulverulent hotmelt adhesive to the partly electrostatically charged surface of the substrate (1) or microcomponent (18), and brief heating of the surface to incipiently melt the adhesive (5) at the electrostatically charged bondsites (7).

11. The method of claim 1, **characterized by** placement of a transfer sheet (15) with granular or pulverulent adhesive (5) attaching thereto, or of a layer produced from hotmelt adhesive, to the adherend surface of the microcomponent (18) or substrate (1).

12. The method of claim 11, **characterized by** contouring of the transfer sheet (15) to select bondsites (7).

13. The method of claim 11, **characterized by** application of the adhesive (5) to selected bondsites (7), when the transfer sheet (15) lies on the surface of at least one microcomponent (18) or substrate (1), by mechanically stamping the transfer sheet (15) onto the substrate (1) or microcomponent (18) or locally heating the transfer sheet (15).

14. The method of one of the preceding claims, **characterized by** preheating of at least the surfaces to which adhesive (5) is applied.

15. The method of one of the preceding claims, **characterized by** afterheating of the microsystem component after the at least one microcomponent (18) has been adhered to the substrate (1).

16. The method of claim 14, **characterized in that** the afterheating takes place selectively by means of focusing heat source (11) or globally.

17. The method of one of the preceding claims, **characterized in that** the granules of the adhesives (5) have a diameter of less than 150 µm.

18. The method of claim 17, **characterized in that** the diameter of the granules is situated in the range from 0.5 to 150 µm.

19. A microsystem component having at least one microcomponent (18) bonded to a substrate (1), **characterized in that** the adhesive bonding is performed by the method of one of claims 1 to 18.

20. The microsystem component of claim 19, **characterized in that** the microcomponents (18) are smaller than 1000 µm.

## Revendications

1. Procédé pour coller des microcomposants (18) sur un substrat (1) lors de la fabrication d'éléments de composant d'un microsystème, comportant les étapes suivantes :
- application sur le microcomposant (18) et/ou sur le substrat (1) d'un adhésif fusible (5) réactif ou non réactif ;
- chauffage de l'adhésif fusible (5), et
- dépôt d'au moins un microcomposant (18) sur le substrat (1), l'adhésif fusible (5) étant sur les surfaces de contact entre le microcomposant (18) et le substrat (1), **caractérisé par**
- une application à plat d'adhésif fusible (5) pulvérulent sur la surface extérieure du substrat (1) ou du microcomposant (18),
- mise en fusion de zones de collage choisies (7) par chauffage local par rayonnement des zones de collage choisies au moyen d'une source de chaleur focalisable (11) de la couche pulvérulente ;
- enlèvement de la couche pulvérulente non fondue ; et
- collage dudit au moins un microcomposant (18) sur le substrat (1).

2. Procédé selon la revendication 1, **caractérisé en ce que** le chauffage est réalisé sélectivement au moyen d'une source de chaleur focalisée en particulier au moyen d'un laser.

3. Procédé selon la revendication 1 ou 2, **caractérisé en ce que** l'adhésif fusible (5) est appliqué sous forme de granules.

4. Procédé selon l'une des revendications précédentes, **caractérisé en ce que** le chauffage est effectué par laser.

5. Procédé selon l'une des revendications précédentes, **caractérisé par** l'immersion d'un substrat (1) ou un microcomposant (18) chauffé, dans un adhésif fusible pulvérulent pour l'application de l'adhésif (5) sur les surfaces immergées.

6. Procédé selon l'une des revendications précédentes, **caractérisé par** l'application d'adhésif fusible pulvérulent à travers d'un tamis de masquage (13) sur le substrat (1) ou le microcomposant (18).

7. Procédé selon l'une des revendications précédentes **caractérisé par** la charge électrostatique d'une surface extérieure et d'un adhésif fusible pulvérulent (5) pour favoriser l'application à plat ou structurée de l'adhésif.

8. Procédé selon l'une des revendications précédentes, **caractérisé par** l'immersion d'une surface extérieure structurée et chauffée du substrat
(1) ou du microcomposant (18) dans de l'adhésif fusible pulvérulent pour l'application de l'adhésif (5) sur les zones désirées de la surface supérieure structurée.

9. Procédé sur l'une des revendications précédentes, **caractérisé par** la charge électrostatique d'un rouleau (12), l'application surfacique de l'adhésif fusible pulvérulent sur la surface partiellement chargée électrostatiquement du rouleau (12) et le transfert des zones de collage (7) choisies du rouleau (12) sur le substrat (1) ou microcomposant (18) et le chauffage rapide de la surface pour faire fondre l'adhésif (5).

10. Procédé selon l'une des revendications précédentes, **caractérisé par** la charge électrostatique d'un rouleau (12), l'application surfacique de l'adhésif fusible pulvérulent sur la surface partiellement chargée électrostatiquement du rouleau (12) et le transfert des zones de collage (7) choisies du rouleau (12) sur le substrat (1) ou microcomposant (18) et le chauffage rapide de la surface pour faire fondre l'adhésif (5) sur les zones de collage (7) chargées électrostatiquement.

11. Procédé selon la revendication 1, **caractérisé par** l'application d'une pellicule de transfert (15) avec un adhésif (5) sous forme de granules ou pulvérulent adhérant à cette pellicule ou une couche préparée d'adhésif fusible sur la surface extérieure à coller du microcomposant (18) ou du substrat (1).

12. Procédé selon la revendication 11, **caractérisé par** la réalisation de contours sur la pellicule de transfert (15) pour sélectionner les zones de collage (7).

13. Procédé selon la revendication 11, **caractérisé par** l'application de l'adhésif (5) sur les zones de collage sélectionnées (7), lorsque la pellicule de transfert (15) recouvre la surface d'au moins un microcomposant (18) ou du substrat (1), par tamponnage mécanique de la pellicule de transfert (15) sur le substrat (1) ou le microcomposant (18) ou chauffage local de la pellicule de transfert (15).

14. Procédé selon l'une des revendications précédentes, **caractérisé par** le préchauffage d'au moins la surface extérieure sur laquelle doit être appliquée l'adhésif (5).

15. Procédé selon l'une des revendications précédentes, **caractérisé par** le chauffage postérieur du composant du microsystème après le collage dudit au moins un microcomposant (18) sur le substrat (1).

16. Procédé selon la revendication 14, **caractérisé en ce que** le chauffage postérieur est effectué sélectivement au moyen d'une source de chaleur (11) focalisée ou globalement.

17. Procédé selon l'une des revendications précédentes, **caractérisé en ce que** les granules de l'adhésif (5) ont un diamètre inférieur à 150 µm.

18. Procédé selon la revendication 17, **caractérisé en ce que** le diamètre des granules est compris entre 0,5 et 150 µm.

19. Elément de composant d'un microsystème comprenant au moins un microcomposant (18) collé sur un substrat (1), **caractérisé en ce qu'**une liaison par collage est effectuée avec le procédé selon l'une des revendications 1 à 18.

20. Elément de composant d'un microsystème selon la revendication 19, **caractérisé en ce que** les microcomposants (18) ont une taille inférieure à 1000 µm.
